# EUROPEAN PATENT APPLICATION

(11) **EP 3 041 131 A1**
(43) Date of publication of application: **06.07.2016**
(21) Application number: 15194406.3
(22) Date of filing: 12.11.2015
(51) Int. Cl.: H02S 20/25, H01L 31/048, B29C 45/14, B29C 45/40

(54) **A METHOD OF MANUFACTURING OF A BUILDING ELEMENT WITH A PHOTOVOLTAIC CELL AND A BUILDING ELEMENT WITH A PHOTOVOLTAIC CELL**

(30) Priority: 16.11.2014 PL 41012414
(71) Applicant: Adamczewski, Marek, 71-075 Szczecin (PL)
(72) Inventor: Adamczewski, Marek, 71-075 Szczecin (PL)
(74) Representative: Eupatent.pl

(57) **Abstract**

A method of manufacturing a building element with a photovoltaic cell, characterized in that it comprises the steps of: providing an injection mold (40, 50) of a shape corresponding to the building element, wherein the first part (40) of the mold comprises a plastic injecting nozzle (41), and the second part (50) of the mold comprises ejectors (51); introducing the photovoltaic cell (10) having a through-hole (15) into the injection mold (40, 50) by placing the through-hole (15) on the nozzle (41) and directing the side of the cell intended for receiving sun rays towards the first part (40) of the mold; injecting plastic to the cavity of the injection mold (40, 50) to form the base (20) of the building element integrated with a substrate (11) of the cell (10); and ejecting the molded building element from the mold (40, 50) by activating the ejectors (51) to act on the base (20) of the building element.

## Description

The present invention relates to a method of manufacturing of a building element comprising a photovoltaic cell, as well as to a building element comprising a photovoltaic cell itself.

Photovoltaic cells, also called solar cells, photoelectric cells or photocells, are elements in which energy of solar radiation is transformed into electric energy as a result of a photovoltaic effect. Such cells may be used as sources of energy in solar power plants, where a plurality of interconnected cells generate energy for supplying a certain device or object.

Recently, organic cells were developed, which are polymer cells utilizing a so-called organic electronic systems (organic electronics). Such cells may be based on organic photovoltaic materials, such as polyphenylene vinylene (PPV), CN-PPV, MEH-PPV, polyacetylene or phthalocyanine.

For example, a US patent US8492647 discloses an organic solar cell which comprises a substrate with a first electrode, a hole transport layer covering the first electrode, a metallic layer, an active layer with two organic semiconductor coatings and a second electrode.

Organic cells are commercially available in form of elastic foils.

For some time, solutions have been used in a building industry, which provide independent energetic power supply or a support for energetic power supply of buildings. For example, photovoltaic panels, which provide certain amount of electric energy, can be mounted on roofs of buildings. Commonly used panels have a form of separate elements, which are mounted on a roof. However, they disrupt the architectural form of the building. Moreover, the cells are heavy, fragile and prone to damage during installation.

Building elements had been developed, such as tiles, which are integrated with photovoltaic cells. This allows for forming an esthetic elevation of a building, particularly a roof, as the photovoltaic panel does not form an element separate from the roof.

A Mexican patent application MX2011008574 discloses a building element in a form of a laminate with a photovoltaic battery detachably mounted to an elastic polymer membrane. Such construction allows for exchange of the battery, in case of its damage, without the need to remove the whole building element from the construction.

There are also known reinforced elements with photovoltaic cells that can be used as building boards: roof panels or wall panels. Such elements are manufactured as flat layered products using the known techniques of laminating that are applied in production of reinforced layered products.

Conventionally, a laminating process may be realized in a continuous or cyclic mode, depending on the selection of machines and devices of the manufacturing line. In the laminating process. the following elements undergo a permanent adhesive bonding: adhesive and at least one layer of a carrier, constituting a substrate layer or an internal layer, where the carrier has a form of sheets, foils, tapes or fibers.

Depending on the selection of the laminating technique, multilayered products in form of flat sheets, tubular profiles or shaped laminates are produced. For example, by the lamination technique using a sprayed material, laminates in a form of elastic or stiff multilayer tapes of any length may be obtained, while by means of a contact lamination technique, flat or shaped elements having dimensions defined by the dimensions of a mold may be obtained. A disadvantage of the contact lamination technique is a relatively high cost of production of an element, due to a long production time of each element and a small degree of automation of production (application of successive layers is typically performed manually). Moreover, another disadvantage of this method is a lack of possibility of producing small elements of a complex shape. For this reason, usually only products of relatively big dimensions, designed to carry significant loads, such as vehicle bodies or anti-corrosion insulation of roofs and containers, are produced by means of the contact lamination.

There are known various layered building elements with photovoltaic cells integrated in a process of lamination.

For example, a Chinese patent application CN101974962 discloses a roofing element in a form of a laminate comprising a photovoltaic cell. The laminate is produced in a double lamination process. In the first step, photovoltaic batteries are laminated while combining them in appropriate modules. After cooling to a room temperature, an intermediate product is subject to a subsequent process, in which modules are arranged on appropriately selected substrate and laminated, what results in a layered product with laminated photovoltaic battery. Double lamination protects the product against harmful effects of environmental factors.

A Chinese patent application CN1944911 discloses an alternative method of production of a multilayered laminate being a roofing element or a wall covering element, wherein a flat cell is introduced between two sheets of material and after lamination, a layered profile with photovoltaic cells is obtained.

Similarly, a Polish patent application PL360084 discloses a layered laminate made of plastic, produced in a continuous process of lamination, in which the photovoltaic battery is one of the layers.

It would be preferable to develop an alternative method of producing building elements comprising a photovoltaic cell.

The object of the invention is a method of manufacturing a building element with a photovoltaic cell. The method comprises the steps of: providing an injection mold of a shape corresponding to the building element, wherein the first part of the mold comprises a plastic injecting nozzle, and the second part of the mold comprises ejectors; introducing the photovoltaic cell having a through-hole into the injection mold by placing the through-hole on the nozzle and directing the side of the cell intended for receiving sun rays towards the first part of the mold; injecting plastic to the cavity of the injection mold to form the base of the building element integrated with a substrate of the cell; and ejecting the molded building element from the mold by activating the ejectors to act on the base of the building element.

The method may comprise providing the mold having the nozzle of a length greater than a thickness of the cell, equal to the thickness of the cell or smaller than the thickness of the cell.

The method may comprise placing an organic photovoltaic cell in the injection mold.

The method may comprise injecting an antistatic plastic into the cavity of the injection mold.

Another object of the invention is a building element with a photovoltaic cell mounted on a plastic base. The building element is made as a molded element, wherein the photovoltaic cell is integrated with the base of the building element in an injection molding process, and wherein the photovoltaic cell has a hole that is open towards the outer surface of the cell.

The hole in the cell can be a through-hole.

The base may comprise a hole that is coaxial with the hole in the cell.

The photovoltaic cell can be an organic cell.

The base of the building element can be formed of an antistatic plastic.

The building element can be a roofing element, in particular a tile.

The building element can be a wall covering element, in particular a facade panel.

The object of the invention has been presented by means of example embodiments in a drawing, in which:
Fig. 1 shows schematically a cross-section of a building element,
Fig. 2 shows exemplary shapes of tiles as examples of a building element,
Fig. 3 shows steps of a method of manufacturing of a building element,
Fig. 4 shows schematically a mold for manufacturing a building element.

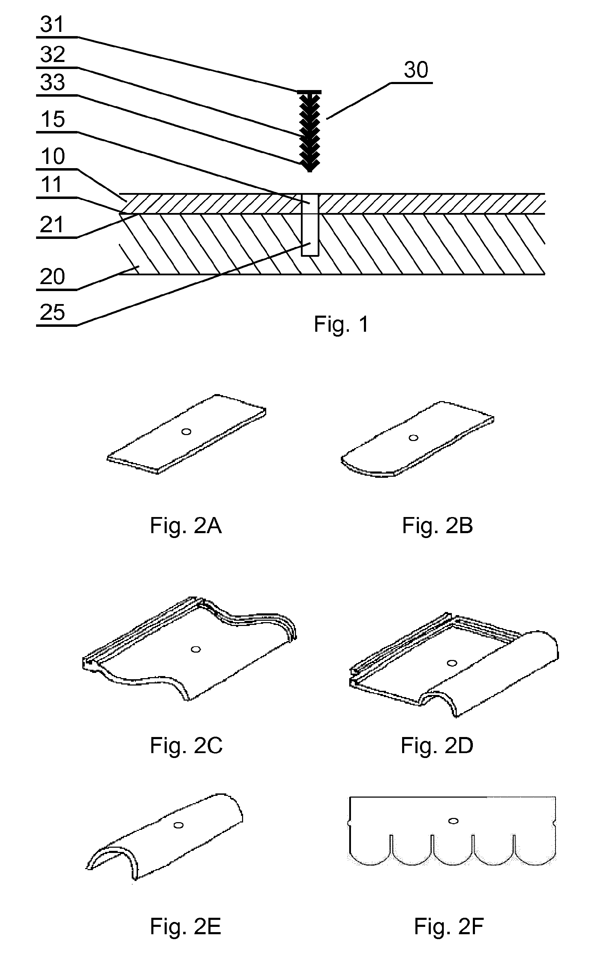

Fig. 1 shows schematically a cross-section of a building element according to the first embodiment. The element comprises a photovoltaic cell 10, preferably an organic cell, having a construction known from the state of the art, in a form of a foil on a plastic substrate. The cell 10 comprises a through-hole 15. The cell 10 is bonded with a base 20 of the building element, which is made of plastic, in a process of injection molding. In the process of injection molding, the lower layer 11 of the substrate of the cell, as a result of high temperature and high pressure of injection of the plastic material, is permanently integrated with the upper layer 21 of the material constituting the base 20 of the building element. An opening 25 that is coaxial with the hole 15 of the cell is formed in the base. In the holes 15, 25, a stopper 30 may be placed, for example having a form of a pin made of elastic plastic, having a head 31 of a diameter greater than the hole 15 and a pin 32 with teeth 33 of a diameter allowing for a tight holding of the stopper 30 in holes 15, 25. The stopper 30 acts as a filler for the holes 15, 25, which prevents the ingress of atmospheric agents, such as wind or rain from one side of the element to the other. The stopper 30 may further comprise a mounting element (not depicted on a drawing) for mounting the building element to the construction, for example a screw that can drill an opening 25.

In another embodiment, the base 20 does not have the hole, and the hole 10 in the cell may be a blind hole that is opened to the outside.

The base 20 of the building element is formed of a plastic, preferably a polymer, for example polypropylene, polyamide, polycarbonate (or other polymers having adequate mechanical properties), to which an antistatic agent can be added. Thereby, the base can be made antistatic, which means it has the ability to prevent generation of electrostatic charges therein, including the ability to reduce (or fully neutralize) the electrostatic charge accumulated on the surface of the base. For example, the base may be made of polypropylene with an addition of Elastostat agent made by BASF Polyurethanes GmbH (Germany) (also called antistatic masterbatch TPU) in an amount of 10% of the final volume of a product. Thereby, the accumulation of electrostatic charges on the surface of the building element is avoided, otherwise the charge without dissipation could be neutralized in an uncontrollable and violent manner.

The thickness of the base depends on factors such as a shape of the building element, a material of which the element is made of and its desired mechanical properties. Preferably, the thickness of the base in its thinnest (narrowest) cross section point is equal to at least 5mm.

Preferably, the substrate of the organic photovoltaic cell 10 and the base 20 of the building element is made of the same plastic, which provides permanent integration among these elements.

The cell 10 may have a multilayered substrate, wherein an upper layer is in contact with the photovoltaic layer, and a lower layer is adapted for a good integration in a process of injection molding with the material of the base of the building element, for example the lower layer can be made of the same plastic as the base of the building element.

Electrical connectors for transporting electrical energy generated by the cell 10 are connected to the organic photovoltaic cell 10. These connectors may have a form of cables, wires, conductive paths etc. integrated with the building element or may be separate elements with respect to the building element. It is not an essential feature of the present invention how to connect particular photovoltaic cells of a plurality of building elements with each other, so it will not be discussed in details.

The building element may form a roof tile, and Fig. 2 shows examples of shapes of the roof tiles. Fig 2A shows a flat tile having a rectangular outline. Fig. 2B shows a flat tile having a rectangular outline with one side rounded. Fig. 2C shows a wavy type of tile called "S". Fig. 2D shows a Roman tile, having a flat part adjacent to a curved part. Fig. 2E shows a Spanish tile, having a cross-sectional shape of semicircle. Fig. 2F shows a tile plate, which has the shape of a longitudinal plate inscribed in the contour of a rectangle, of which one long side is straight and the other long side is composed of shaped elements, in this case in the form of semicircles.

Preferably, the largest surface of a tile, which after laying a tile on the roof is exposed to sun rays, is covered with an organic photovoltaic cell 10. Preferably, the organic photovoltaic cell 10 covers more than 90% of this surface. The mounting surface, i.e. the surface which is usually located at the edges of a tile (especially in case of exemplary tiles shown in Fig. 2C, 2D) may be deprived of the organic layer of the photovoltaic cell 10, because sun rays do not reach it.

The building element may have other forms than these depicted on Figs. 2A-2F, for example it may have a form of flat or shaped panels, dedicated for covering large surfaces such as roofs or side walls of buildings, for example façade panels.

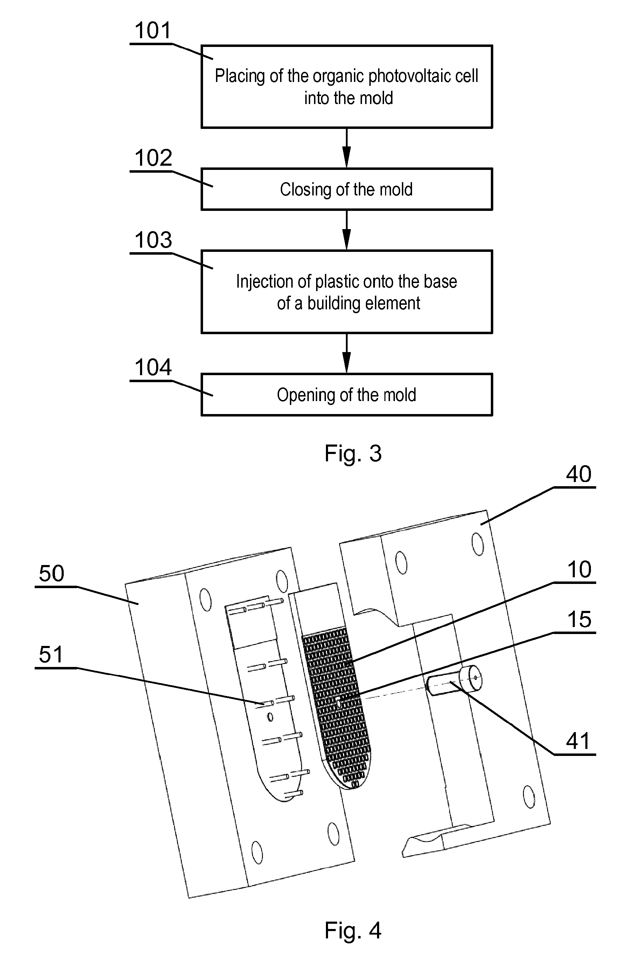

Fig. 3 shows the steps of a method of manufacturing of a building element. The building element is manufactured in a process of injection molding, similar to in-mold labeling process, by which different kinds of containers with information labels, such as bottles, cups or other containers for food are produced. However, unlike the in-mold labeling process for containers, which is a field of technology distinct from the field of manufacturing of building elements, the layer forming the base of the construction element is much thicker: it is preferably greater than 5 mm, preferably greater than 10 mm, (while the container wall thickness is usually about 1-5 mm). In the first step 101, the photovoltaic cell 10 with the hole 15 is introduced into the injection mold having a shape shown schematically in Fig. 4, corresponding to the shape of the building element to be molded. Preferably, a photovoltaic cell in a form of elastic foil is used, which can be adapted to the shape of the walls of the mold, which don't have to be necessarily flat, for example in order to produce elements depicted in Fig. 2C-2E. The cell 10 is placed in the mold so that the layer intended for receiving sun rays is adjacent to the wall of first part 40 of the mold, in which the nozzle 41 for injecting the plastic is positioned. The first part 40 of the mold is presented in the Fig. 4 in a partial cross section, for better visualization of the position of the nozzle 41. The lower layer of the substrate of the cell 10 is facing to the inside of the mold, towards the second part 50 of the mold, in which ejectors 51 are positioned (the ejectors are shown in Fig. 4 for clarity in an ejected position, into which they move after the mold is opened, in order to eject the molded element). Next, in step 102 the mold is closed, which makes the nozzle 41 to come through the hole 15. In step 103, plastic is injected into the mold at an appropriate pressure. The material introduced through the nozzle 41 passes towards the substrate side of the cell 10 and under high temperature and pressure, the material fills the cavity of the mold and permanently integrates with the substrate of the cell 10. After cooling of the material, the mold is opened in step 104 and the molded building element is ejected by means of ejectors 51 acting on the cured plastic.

The length of the nozzle 41 (measured as a distance, by which the nozzle 41 protrudes form the wall of the first part 40 of the mold) determines the depth of the injection of the material through the hole 15 in the cell 10. If the nozzle 41 has a length equal to the thickness of the cell 10, then the base 20 will be molded on the bottom side of the cell, without the hole. If the nozzle 41 has a length smaller than the thickness of the cell 10, then an element with a blind hole in the cell 10 will be molded. If the nozzle 41 has a length greater than the thickness of the cell 10, then an element with a through-hole 15 in the cell 10 and the blind hole 25 in the base 20 will be formed.

An important element of the presented method is the use of the cell 10 with the hole 15, which is placed in the mold so that the injection of the material takes place from the direction of the side intended for receiving sun rays through the hole 15 to the substrate 11 of the cell 10. Thereby, during the injection process, the plastic material molten to a high temperature, which is injected into the mold under high pressure, acts directly on the substrate 11 of cell 10 and a delicate layer intended for receiving sun rays is isolated from the material. Moreover, after the material is cured, the molded element is ejected by means of ejectors 51 placed on the other side of the cured material, thereby there is no risk of damaging the delicate layer intended for receiving sun rays, by the ejectors 51. The hole 15 in the cell 10 thereby allows for application of the mold in which ejectors 51 are placed in the part 50 of the mold opposite to the part 40 in which the nozzle 41 is placed, which makes the construction of the mold simpler.

## Claims

1. A method of manufacturing a building element with a photovoltaic cell, **characterized in that** it comprises the steps of:
- providing an injection mold (40, 50) of a shape corresponding to the building element, wherein the first part (40) of the mold comprises a plastic injecting nozzle (41), and the second part (50) of the mold comprises ejectors (51);
- introducing the photovoltaic cell (10) having a through-hole (15) into the injection mold (40, 50) by placing the through-hole (15) on the nozzle (41) and directing the side of the cell intended for receiving sun rays towards the first part (40) of the mold;
- injecting plastic to the cavity of the injection mold (40, 50) to form the base (20) of the building element integrated with a substrate (11) of the cell (10); and
- ejecting the molded building element from the mold (40, 50) by activating the ejectors (51) to act on the base (20) of the building element.

2. The method according to claim 1, **characterized by** providing the mold having the nozzle (41) of a length greater than a thickness of the cell (10).

3. The method according to claim 1, **characterized by** providing the mold with the nozzle (41) of a length equal to the thickness of the cell (10).

4. The method according to claim 1, **characterized by** providing the mold with the nozzle (41) of a length smaller than the thickness of the cell (10).

5. The method according to any of previous claims, **characterized by** placing an organic photovoltaic cell (10) in the injection mold (40, 50).

6. The method according to any of previous claims, **characterized by** injecting an antistatic plastic into the cavity of the injection mold (40, 50).

7. A building element with a photovoltaic cell mounted on a plastic base, **characterized in that** the building element is made as a molded element, wherein the photovoltaic cell (10) is integrated with the base (20) of the building element in an injection molding process, and wherein the photovoltaic cell (10) has a hole (15) that is open towards the outer surface of the cell (10).

8. The building element according to claim 7, **characterized in that** the hole (15) in the cell (10) is a through-hole.

9. The building element according to any of claims 7-8, **characterized in that** the base (20) comprises a hole (25) that is coaxial with the hole (15) in the cell (10).

10. The building element according to any of claims 7-9, **characterized in that** the photovoltaic cell (10) is an organic cell.

11. The building element according to any of claims 7-10, **characterized in that** the base (20) of the building element is formed of an antistatic plastic.

12. The building element according to any of claims 7-11, **characterized in that** it is a roofing element, in particular a tile.

13. The building element according to any of claims 7-12, **characterized in that** it is a wall covering element, in particular a facade panel.
